(19) Europäisches Patentamt

European Patent Office

Office européen des brevets

(11) **EP 1 071 226 A1**

(12) **EUROPEAN PATENT APPLICATION**

(43) Date of publication:
**24.01.2001 Bulletin 2001/04**

(51) Int. Cl.[7]: **H04B 7/005**, H03G 3/30

(21) Application number: **00305859.1**

(22) Date of filing: **11.07.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **19.07.1999 US 356825**
**30.08.1999 US 385305**

(71) Applicant:
**LUCENT TECHNOLOGIES INC.**
**Murray Hill, New Jersey 07974-0636 (US)**

(72) Inventors:
• **Bi, Qi**
**Morris Plains, New Jersey 07950 (US)**

• **Eibling, Edward Ellis**
**Convent Station, New Jersey 07961 (US)**
• **Kamel, Raafat Edward**
**Westfield, New Jersey 07090 (US)**
• **Kuo, Wen-Yi**
**Morganville, New Jersey 07751 (US)**
• **Thomas, Mathew**
**Scotch Plains, New Jersey 07076 (US)**
• **Weaver, Carl Francis**
**Morris Plains, New Jersey 07950 (US)**

(74) Representative:
**Buckley, Christopher Simon Thirsk et al**
**Lucent Technologies (UK) Ltd,**
**5 Mornington Road**
**Woodford Green, Essex IG8 0TU (GB)**

(54) **Aggregate overload power control**

(57)      A method that changes the power level of a set of forward-link signals, independent of the individual power control of each of the forward-link signals in the set, responsive to a comparison of the signal set's power level and a threshold power level ($P_{th}$). The threshold power level ($P_{th}$) is based on the base station's (200) amplifier's (150) maximum threshold power level. The power level of the set is changed by scaling it by a scaling factor. The total power level ($P[n-1]$) of the set is obtained during a current frame, and then the scaling factor ($g[n]$) that will be used in the subsequent frame is determined. The scaling factor ($g[n]$) is preferably based on the total power level ($P[n-1]$) of the set for the current frame, a scaling factor ($g[n-1]$) used during the current frame, and a threshold power level ($P_{th}$). The amount by which the total power level exceeds the amplifier's maximum continuous power level is the overload amount. The scaling factor is selected so that for each frame the overload amount is reduced by a percentage. For example, the overload amount can be reduced by 3% for the current frame, then the percentage may be changed for a subsequent frame based on the scaling factor of the current time period and the overload amount of the subsequent time period. The set can include all of the signals amplified by the base station's amplifier (150); alternatively, the set can include fewer than all the signals generated by the base station. For example, the set can include a plurality of the traffic signals, or a plurality of the traffic signals and one or more of the control signals. When the base station includes a plurality of amplifiers, each for amplifying a set of signals, the above process can be performed for each of the sets of signals.

FIG. 2

**Description**

**Cross-Reference To Related Application**

This application is a Continuation-in-Part of U.S. patent application "Aggregate Overload Power Control", Serial No. 09/356,825 filed on July 19, 1999 and assigned to the same Assignee hereof.

Related subject matter is disclosed in U.S. patent application "Method For Initiating Call Blocking", Serial No. 09/356,816 assigned to the same Assignee hereof.

**Background of the Invention**

Field of the Invention

The present invention relates generally to wireless communication systems and, in particular, to power control in wireless communication systems.

Description of the Related Art

Wireless communication systems employ Code Division Multiple Access ("CDMA") modulation techniques to permit a large number of system users to communicate with one another. The ability of such a system to work is based on the fact that each signal is coded with spreading sequences, such as with a pseudo-random noise ("PN") sequence, and orthogonal spreading sequences such as Walsh codes. This coding permits signal separation and signal reconstruction at the receiver. In typical CDMA systems, communication is achieved by using a different spreading sequence for each channel. This results in a plurality of transmitted signals sharing the same bandwidth. Particular transmitted signals are retrieved from the communication channel by despreading a signal from all of the signals by using a known user despreading sequence related to the spreading sequence implemented at the transmitter.

The geographic area serviced by a CDMA system is divided into a plurality of spatially distinct areas called "cells." Each cell contains one base station that includes equipment to communicate with a Mobile Switching Center ("MSC"), which is connected to a local and/or long-distance transmission network, such as a public switch telephone network (PSTN). Each base station also includes modems, radios, and antennas, which it uses to communicate with mobile terminals. When a call is set up in a CDMA system, a base station and mobile terminal communicate over a forward link and a reverse link. The forward link includes communication channels for transmitting signals from the base station to the mobile terminal, and the reverse link includes communication channels for transmitting signals from the mobile terminal to the base station. The base station transmits certain types of control information to the mobile terminal over a communication channel, referred to herein as a forward control channel, also known in the art as a forward overhead channel. Forward control channels include the pilot, paging, and synchronization channels. The base station transmits voice or data, and certain types of control information over a communication channel, referred to herein as a forward traffic channel. The signals on the communication channels are organized in time periods, referred to herein as frames. Frames are typically 20-millisecond (ms) in length. The signals transmitted over the control channels are referred to herein as control signals, and the signals transmitted over the traffic channels are referred to herein as traffic signals.

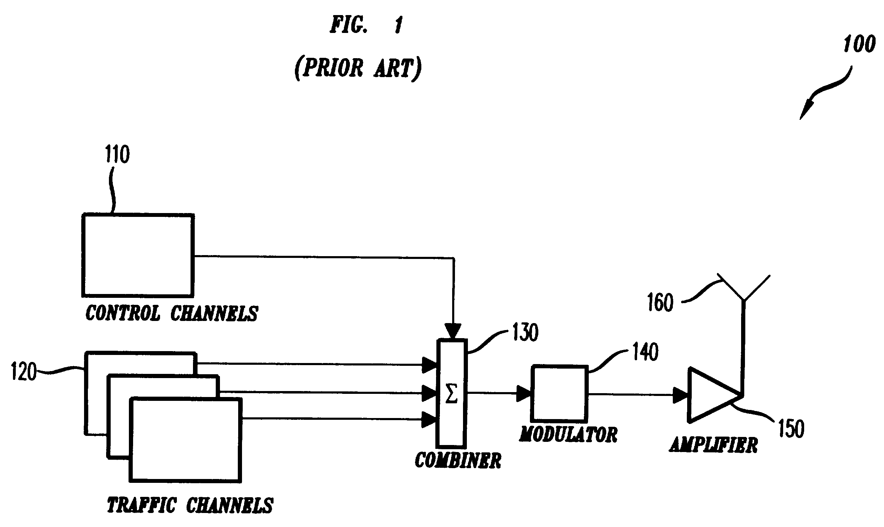

Figure 1 shows a portion of base station 100. Each signal is the output of one of channel elements 110, 120. The channel elements encode the data with the spreading codes. The control signals are the output of control-channel channel elements 110, and the traffic signals are the output of traffic-channel channel elements 120. The output of the channel elements 110, 120 is coupled to combiner 130 where all of the signals are digitally combined to form a combined-baseband signal. The combined-baseband signal is then input into modulator 140 where the signal is slightly amplified and is modulated onto a carrier signal. The modulated signal is amplified suitably in amplifier 150. Therefore, the combined-baseband signal is amplified by the gain of modulator 140 plus the gain of amplifier 150, referred to herein as the path gain of the transmission path. The signal is then transmitted via the antenna 160 to the mobile terminals.

The base station may implement two forms of power control: individual power control for each traffic signal, which is implemented by most base stations, and overload power control, which is implemented by only some of the base stations.

In the case of the individual power control, the base station determines the power level of the forward link to each mobile terminal independent of the power levels of the forward links of the other mobile terminals communicating with the base station. Each mobile terminal receives the transmitted signal and obtains the forward signal intended for that mobile terminal. When a mobile terminal is receiving a traffic signal, it checks to determine whether the received forward traffic frame is in error. In a subsequent reverse traffic frame that the mobile terminal transmits, the mobile terminal indicates to the base station whether there was an error. Upon receiving reverse traffic frames from the mobile terminal, the base station determines whether its forward link to this mobile terminal is in fading, and adjusts the power of its forward link accordingly. For example, if the base station receives one or more successive indications that there is an erred forward traffic frame, the base station may determine that its forward link is in fading and increase the power of its forward link.

A goal of overload power control is to ensure that the total power transmitted by the base station does not exceed the power level at which the base station's equipment is designed to operate over an extended time period. Overload power control is beneficial when the number of signals that can be transmitted simultaneously by the base station is limited by the total power of all the transmitted signals. Thus, reducing the power of the signals increases the capacity of the wireless communication system. However, reducing the power of a signal may increase the number of errors in that signal. A goal of power control is to keep the power level as close as possible to a level that allows the maximum capacity while keeping the number of errors in the signal at an acceptable level.

The total power of all the transmitted signals is a limiting factor for the number of signals that can be transmitted simultaneously because there is maximum output power level at which the amplifier 150 is designed to operate over an extended time period. This maximum output power is referred to herein as the amplifier's maximum continuous power level. When the power level reaches the amplifier's maximum continuous power level an overload condition exists. The base station should determine how much total power is being transmitted, such that the amplifier's maximum continuous power level is not exceeded when additional power is requested.

For example, when additional power is requested of a base station that employs no forward link overload power control, the power requests are continued to be accepted, potentially reaching an overload condition. This overload condition can damage the base station, requiring repair or replacement of equipment.

Conventional CDMA systems that have some form of overload power control may cause other problems and still not be able to solve the problem of reaching an overload condition. A controller or processor within the base station typically receives the power levels of all the signals that are amplified by one amplifier. The controller then sums the power levels and compares the resulting total with the amplifier's maximum continuous power level to determine if there is an overload condition. If the controller determines that there is an overload condition, the base station implements one of several remedies. These remedies typically include: a) denying access to any new call requests, referred to herein as call blocking; b) restricting the transmitted signal to its current level; or c) even clipping the transmitted signal.

Nevertheless, the overload power control may still fail to prevent the base station from reaching an overload condition due to the rapid variations in the power demand of individual traffic channels and the relatively slow feedback used to provide overload power control. As a result, conventional base stations can exceed amplifier 150's maximum continuous power level and thereby damage amplifier 150. These drawbacks of conventional base stations have required an over-design of the amplifiers to cope with the overload conditions. Extra margin on the amplifier translates into more expensive and larger systems that do not guarantee that the base station will perform without overloads.

Summary of the Invention

The invention solves the above problems by changing the power level of a set of forward-link signals of a base station, independent of the individual power control of each of the forward-link signals in the set, responsive to a comparison of the signal set's power level and a threshold power level. The threshold power level is based on the base station's amplifier's maximum threshold power level. The power level of the set is changed by scaling it by a scaling factor. The total power level of the set is obtained during a current time period, and then the scaling factor that will be used in the subsequent time period is determined. The scaling factor is preferably based on the total power level of the set for the current time period, a scaling factor used during the current time period, and a threshold power level. The amount by which the total power level exceeds the amplifier's maximum continuous power level is the overload amount. The scaling factor is selected so that for each time period the overload amount is reduced by a percentage or a fixed factor. For example, the overload amount can be reduced by 3% for the current time period, then the percentage may be changed for a subsequent time period based on the scaling factor of the current time period and the overload amount of the current time interval.

The set can include all of the signals amplified by the base station's amplifier, alternatively, the set can include fewer than all the signals generated by the base station. For example, the set can include a plurality of the traffic signals, or a plurality of the traffic signals and one or more of the control signals.

When the base station includes a plurality of amplifiers, each for amplifying a set of signals, the above process can be performed for each of the sets of signals.

Changing the power level of a set of forward-link signals, independent of the individual power control of each of the forward-link signals in the set allows the wireless communication system to operate at a lower power level, thus protecting the amplifier. It also allows a mobile terminal requiring additional power to obtain the additional power, even when the set's power level is close to or exceeds the amplifier's maximum continuous power level, since the set's power level can be reduced to provide the additional power. Allowing a mobile terminal requiring additional power to obtain the additional power permits the mobile terminal to get the power needed to keep the number of errors at an acceptable level.

Brief Description of the Drawings

Figure 1 is a block diagram of a portion of a conventional base station;
Figure 2 is a block diagram of a portion of a base station with overload control where the combined-traffic-baseband-signal is scaled by a scaling factor obtained using the combined-traffic-baseband-signal;
Figure 3 is a block diagram of an overload control element of the base station;
Figure 4 is a block diagram of a portion of a base station with overload control where the combined-baseband-signal is scaled by a scaling factor obtained using the combined-baseband-signal;
Figure 5 is a block diagram of a portion of a base station with overload control where the traffic signals are individually scaled by the scaling factor obtained using the combined-traffic-baseband-signal; and
Figure 6 is a block diagram of a portion of a base station with overload control where the traffic and control signals are individually scaled by the scaling factor obtained using the combined-baseband-signal.

Detailed Description

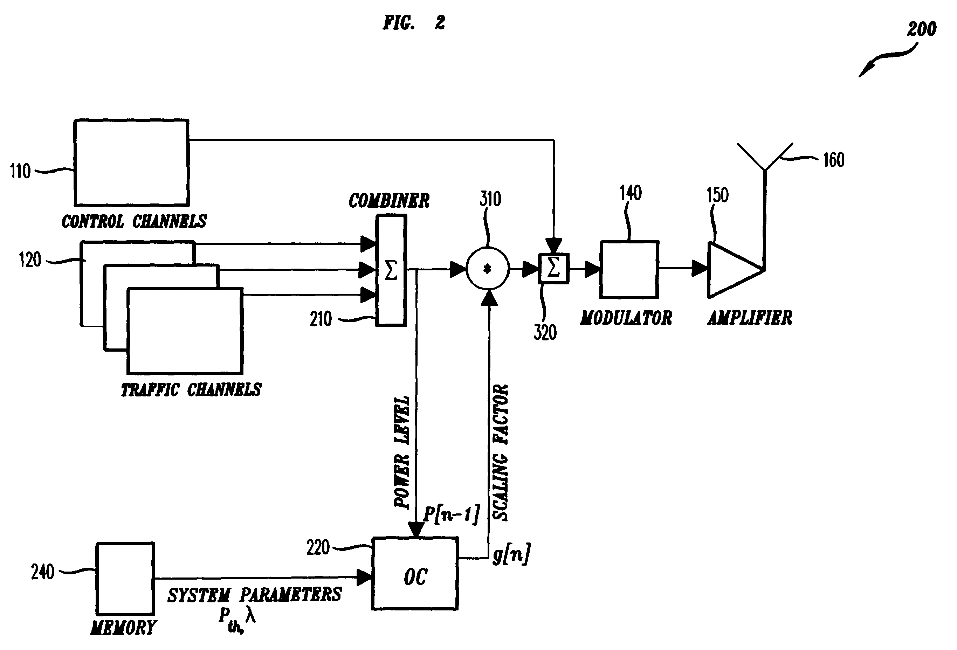

Figure 2 shows a portion of base station 200 in a CDMA system. Although the embodiment of the invention is being illustrated with the use of a CDMA system, the invention is not limited to use in CDMA systems. The invention may be equally applicable to any wireless communication system, such as Time Division Multiple Access ("TDMA") systems, and Global System for Mobile (GSM) systems, or any other wireless communication system where multiple signals are amplified by one amplifier.

Each of the base station's signals is the output of one of channel elements 110, 120. The control signals are the output of control-channel channel elements 110, and the traffic signals are the output of traffic-channel channel elements 120. The output of the traffic channel elements 120 is coupled to combiner 210 where the traffic signals are combined together to form a combined-traffic-baseband signal. The traffic signals are organized in frames, which, as described above, are typically 20 ms time periods. The total power level of the current frame P[n-1] of the signal is measured. This total power level is the input to overload control element 220.

An overload condition exists when the power level of the combined-traffic-baseband signal amplified by the transmit-path gain is larger than amplifier 150's maximum continuous power level. As described above, the transmit-path gain is the sum of the gains of modulator 140 and amplifier 150. The amount by which the total power level exceeds the amplifier's maximum continuous power level is the overload amount. The goal of overload control is to gradually reduce the overload amount so that when the combined-traffic-baseband signal is amplified by the transmit-path gain the resulting signal will be smaller than or equal to the amplifier's maximum continuous power level. The overload amount can be reduced in any manner. For example, the overload amount can be reduced by scaling the combined-traffic-baseband signal by a scaling factor. The scaling factor is selected so that for each frame the overload amount is reduced by a percentage or a fixed factor. For example, the overload amount can be reduced by 3% for the current frame, then the percentage may be changed for a subsequent frame based on the scaling factor of the current time period and the overload amount of the current time period.

Overload control element 220 uses the power level of the current frame P[n-1], $\lambda$, and power threshold $P_{th}$, to determine scaling factor g[n] that is to used to scale the total power level of the subsequent frame P[n]. Power control threshold $P_{th}$ is a factor of the amplifier's maximum continuous power level. $\lambda$ controls how rapidly the scaling factor changes in response to variations in the power level from one frame to another frame. $\lambda$ is selected to balance a desire to return the system from the overload condition as quickly as possible and a desire to have a smoothly varying control function, a typical value for $\lambda$ can be between about 2 and 20. Power control threshold $P_{th}$ is chosen based on the amplifier's capabilities and on the aggressiveness of the overload control policy. The aggressiveness of the overload control policy is a design choice based on balancing the desire to increase the capacity of the system and the desire to ensure that the amplifier does not exceed its maximum continuous power level for a long enough period to damage the amplifier. Power control threshold $P_{th}$ can be any value in the range of about 75% to about 150% of the amplifier's maximum continuous power level. In order for power control threshold $P_{th}$ to be over 100%, the amplifier should be an enhanced amplifier that is over-designed to be able to produce a power level somewhere between its maximum continuous power level and its maximum peak power level for some period of time, such as several seconds. The amplifier's peak power level is the level above which the amplifier cannot function.

The amplifier can be derated, meaning that the base station is designed with the assumption that the amplifier should only be operated for an extended time period at a derated power level. The derated power level is a power level smaller than the maximum output power level at which the amplifier 150 is designed to operate under nominal conditions over an extended time period. If the amplifier is derated, then the amplifier's derated power level is the amplifier's maximum continuous power level. This value is then used to calculate the power control threshold $P_{th}$ as described above.

As shown in equation 1, the value of scaling factor g[n] is a product of the previous values of the scaling factor g[n-1], and an adjustment factor based on $\lambda$ and the ratio of power threshold $P_{th}$ to power level P[n-1] scaled by $\lambda$.

$$g[n] = g[n\text{-}1]\left[(1\text{-}\tfrac{1}{\lambda})+\tfrac{1}{\lambda}*\left(\frac{P_{th}}{P[n\text{-}1]}\right)\right] \qquad (1)$$

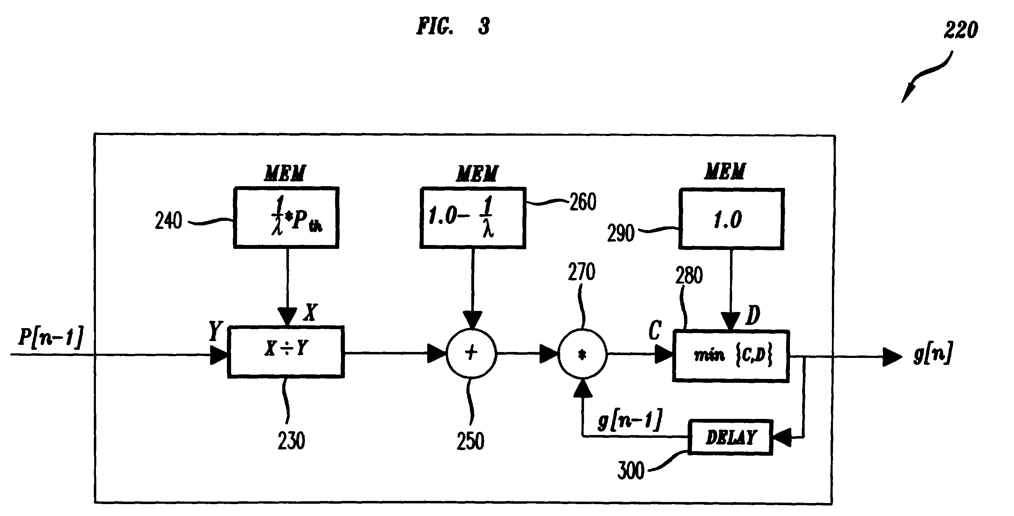

Overload control element 220 implements equation 1. Figure 3 shows overload control element 220 in more detail. Divider 230 divides the power level of the current frame P[n-1] into the product of $\tfrac{1}{\lambda}$ and power threshold $P_{th}$. [Note: this product can be stored in memory 240, or the two values can be stored individually and their product can be obtained in the overload control element 220.] Summer 250 adds the result of divider 230 and $1\text{-}\tfrac{1}{\lambda}$, which can be stored in memory 260. The result of summer 250 is a ratio that indicates if the power level of the current frame P[n-1] is larger than power threshold $P_{th}$. When the result of summer 250 is smaller than one, the power level of the current frame P[n-1] is larger than power threshold $P_{th}$, and there is an overload condition. For example, if the power threshold $P_{th}$ is 10 W, $\lambda$ is 10, and the power level for the current frame is 15 W, then the result of summer 250 is

$$\left[1\text{-}\frac{1}{10} + \frac{1}{10} * \left(\frac{10}{15}\right)\right] = [1\text{-}.1+.1*.667] = [1\text{-}.1+.0667] = .967.$$

Multiplier 270 multiplies the result of summer 250 and the scaling factor obtained for the last frame g[n-1] to obtain smoothly varying overload control. Comparator 280 selects the minimum of the resulting value and 1, which can be stored in memory 290 to obtain scaling factor g[n]. When there is an overload condition, the result of multiplier 270 is less than one, and comparator 280 selects this result to be the scaling factor. When there is no overload condition, the result of multiplier 270 is greater than one, and comparator 280 selects one as the scaling factor. Scaling factor g[n] is compared with one because when there is no overload condition, the power level need not be scaled. Scaling factor g[n] is an input of delay circuit 300, which is typically one or more flip-flops, where it is delayed by one frame to be used as an input of multiplier 270 for the next frame. Although the overload control circuit 220 is shown as being implemented in hardware, it can be implemented in software.

Scaling factor g[n] is also an input of multiplier 310, as shown in Figure 2, where it scales the power level of the subsequent frame P[n]. Each power level is scaled by a scaling factor obtained using the power level of the last frame. However, the delay between the frame whose power level is used to obtain the scaling factor, and the frame whose power level is scaled by the scaling factor can be made larger or smaller based on the speed of overload control circuit 220. For example, if the circuitry of overload control circuit 220 is fast enough, or if the traffic signals can be delayed until the scaling factor is obtained, the power level can be scaled by a scaling factor obtained using the power level of the current frame. The traffic signal can be delayed by adding a pipeline delay between combiner 210 and multiplier 310.

Multiplier 310 multiplies scaling factor g[n] and the signal that forms the subsequent frame P[n], thereby scaling the power level of all of the traffic signals by the same amount. The signal with the now scaled power level is combined with the control signals in combiner 320. The result is then input into modulator 140 where the signal is slightly amplified and is modulated onto a carrier signal. The modulated signal is amplified in amplifier 150 and then transmitted via the antenna 160 to the mobile terminals.

This scaling is performed independent of the conventional individual power control of each of the traffic signals. Therefore, when a mobile terminal determines that the received forward traffic frame is in error, or when it determines that the number of frames in error divided by the total number of frames observed is above an acceptable level, the mobile terminal still indicates this situation to the base station. The mobile terminal indicates this situation to the base station in the next reverse traffic frame that the mobile terminal transmits. Upon receiving reverse traffic frames from the mobile terminal, the base station determines whether its forward link to this mobile terminal is in fading, and adjusts the power level of the traffic signal to this mobile terminal accordingly, prior to the signal on the traffic channel being summed in combiner 210. The signal on that traffic channel is then combined with the signals from other traffic channels, and then, if necessary, scaled. Preferably, the individual power control of each of the traffic signals includes a maximum power level above which a traffic signal's power level is not allowed to go. If a traffic signal's power level is at this maximum power level, and the mobile terminal receiving this traffic signal indicates to the base station to increase the power level of this traffic signal the base station will not further increase the power level of this traffic signal.

The method for overload power control can be used with other methods of overload control. For example, the method for overload power control can be used with the method for initiating call blocking disclosed in U.S. patent application "Overload Control Utilizing Call Blocking", Serial No. _____,_____, incorporated herein by this reference. This method initiates call blocking responsive to a call-quality measurement of the forward link. The call-quality measurement is a measurement of how well a mobile terminal is able to receive the forward link.

One call-quality measurement is a pilot fraction of the forward link, which is a ratio of the pilot's power level to the power level of a set of forward-link signals of a base station. Call blocking can be initiated when the average pilot fraction is below a pilot-fraction blocking threshold. The pilot's power level is obtained for a time period, and the set's power level is obtained for the same time period. The pilot fraction is determined for the time period, and then used to determine an average pilot fraction for the time period. The average pilot fraction for the current time period is based on a pilot fraction for the current time period, and an average pilot fraction for a previous time period. When the average pilot fraction is below the pilot-fraction blocking threshold, call blocking is initiated. The pilot-fraction blocking threshold is preferably based on: 1) the pilot fraction when the base station is at full load; 2) the size, shape, and terrain of the cell; and 3) the aggressiveness of the overload control. In the preferred embodiment, the set includes all of the signals generated by the base station, alternatively, the set can include fewer than all the signals generated by the base station. For example, the set can include a plurality of traffic signals, or a plurality of traffic signals and one or more of the control signal. If the cell includes several sectors, the call blocking is initiated on a sector basis when the average pilot fraction of the sector is below the pilot-fraction blocking threshold.

Other call-quality measurements, such as the forward link's frame error rate or the number of dropped calls, can be used, alone or in combination, instead of or in addition to the pilot fraction of the forward link to determine whether call blocking should be initiated. Determining whether call blocking should be initiated using one of the other call-quality measurements is performed in a similar manner as for the pilot fraction. Determining whether call blocking should be initiated using several call-quality measurements involves determining whether call blocking should be initiated based on any of the call quality measurements and initiating call blocking when any one of the call-quality measurements indicates that call blocking should be initiated. Alternatively, call blocking can be initiated when several of the call quality measurements indicate that call blocking should be initiated.

The foregoing is merely illustrative. Thus, for example although in the illustrative embodiment the time period is one frame, any time period can be used during which a power level measurement of the forward link can be taken. For example, the time period can be several frames, or one or several power control groups, which are time periods having a length of 1/16 of a frame.

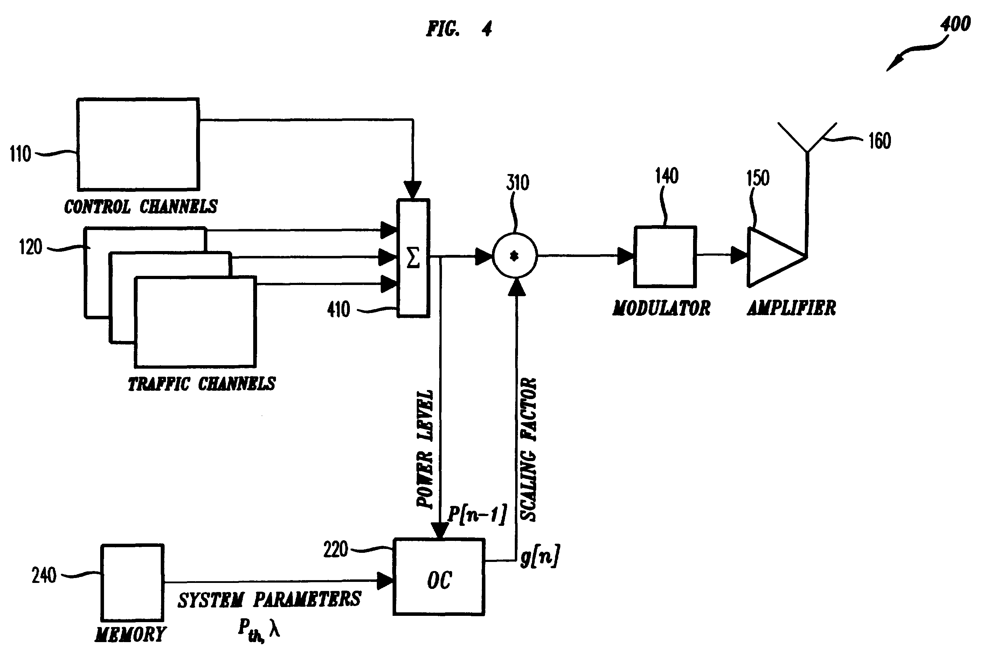

Furthermore, in the illustrative embodiment only the traffic signals are scaled by the scaling factor. As shown in Figure 4, in an alternative embodiment both the traffic and the control signals can be combined in combiner 410 to obtain a combined-baseband signal. The combined-baseband signal is input into the overload control element 220 to determine the scaling factor. The combined-baseband signal and the scaling factor are multiplied in multiplier 310, thus scaling the combine-baseband signal by the scaling factor. The scaled combined-baseband signal is then slightly amplified and is modulated onto a carrier signal by modulator 140. The modulated signal is amplified suitably in amplifier 150 and then transmitted via the antenna 160 to the mobile terminals.

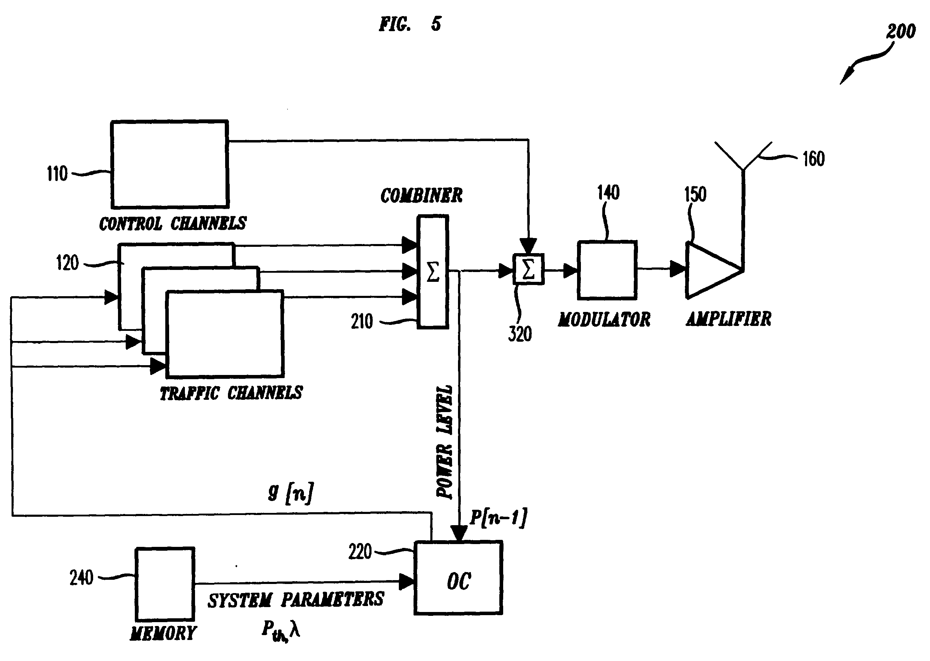

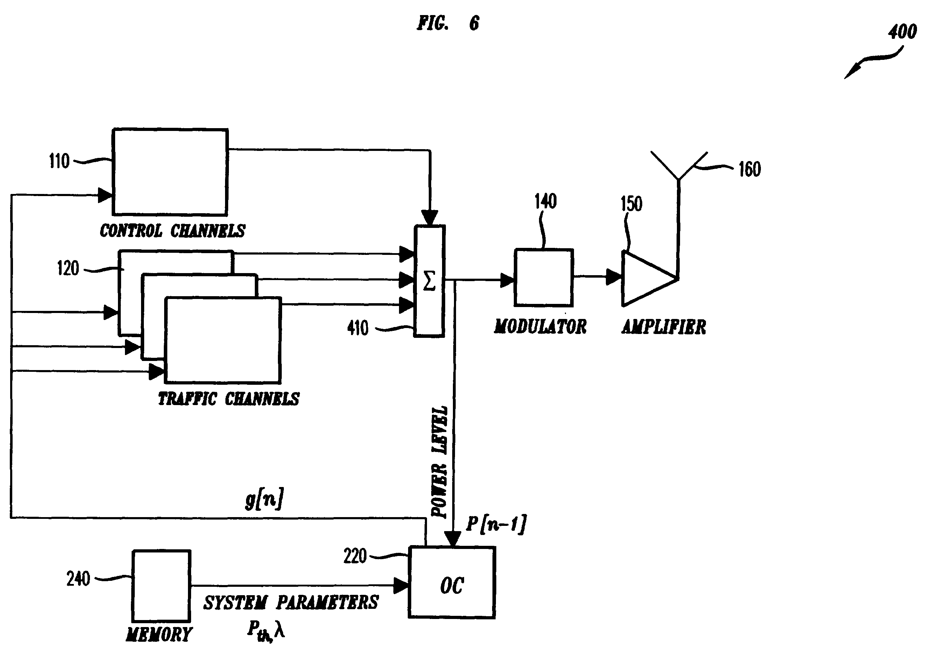

Additionally, in the illustrative embodiments either the combined-traffic-baseband signal is scaled, as shown in Figure 2, or the combined-baseband signal is scaled, as shown in Figure 4. In alternative embodiments, the individual signals can be scaled using the scaling, as shown in Figure 5 and Figure 6. For example, as shown in Figure 5, the scaling factor is still obtained using the combined-traffic-baseband signal. However, instead of multiplying the combined-traffic-baseband signal by the scaling factor in multiplier 310, the scaling factor can be provided to control elements 120 where the individual signals can be scaled by the scaling factor. As shown in Figure 6, the scaling factor is obtained using the combined-baseband signal. However, instead of multiplying the combined-baseband signal by the scaling factor in multiplier 310, the scaling factor can be provided to control elements 110 and 120 where the individual signals can be scaled by the scaling factor.

Still further, although in the illustrative embodiment the method is implemented in hardware, it can be implemented in software.

Moreover, in the illustrative embodiment scaling factor for the current time period is based on a ratio of the power threshold $P_{th}$ to the power level $P[n-1]$ of the current frame, and a scaling factor of the previous frame. In an alternative embodiment the scaling factor for the current frame can be based on the ratio of the power threshold $P_{th}$ to the power level $P[n-1]$ of the current frame, and the ratios, averaged over a plurality of frames, of the power threshold $P_{th}$ to the power level $P[n-1]$ of the current frame.

Additionally, one skilled in the art will recognize that although in the illustrative embodiment each cell is an omni sector, the cell can be divided into a plurality of sectors, with each sector having its own channel elements, radios, which include a modulator and an amplifier, and antennas. In this case, the power measurement is taken on a per-sector basis and input into an overload control element. The resulting scaling factor is then applied to the signals in the sector. Each sector can have its own overload control element, or, alternatively, one overload control element can be used for all the sectors.

Moreover, although in the illustrative embodiment the channel elements are shown in parallel, with the resulting signals combined in one combiner, the channel elements can be set up in series. In this case, the signal from each channel element is combined with signals from the previous channel elements in the series.

While the invention has been described with reference to a preferred embodiment, it will be understood by those skilled in the art having reference to the specification and drawings that various modifications and alternatives are possible therein without departing from the spirit and scope of the invention.

## Claims

1.  A method for controlling a power level of signals transmitted by a base station (200, 400) in a wireless system, the base station (200, 400) having a set of signals amplified by an amplifier (150) the method CHARACTERIZED BY the step of changing the power level of the set of signals, independent of an individual power control of each of the signals in the set, responsive to a comparison of the signal set's power level and a threshold power level ($P_{th}$) that is based on the amplifier's maximum continuous power level.

2.  The method of claim 1, CHARACTERIZED IN THAT the changing step comprises changing the power level of each of the signals in the signal set individually responsive to the comparison of the signal set's power level and the threshold power level that is based on the amplifier's maximum continuous power level.

3.  The method of claim 1, CHARACTERIZED IN THAT the changing step comprises:

    obtaining a power level of the set of signals for a time period;
    determining a scaling factor based on the threshold power ($P_{th}$); and
    scaling the power level of the set of signals using a corresponding scaling factor.

4.  The method of claims 1 or 3, CHARACTERIZED IN THAT the set of signals comprises all the signals amplified by the amplifier.

5.  The method of claims 1 or 3, CHARACTERIZED IN THAT the set of signals comprises a plurality of traffic signals.

6.  The method of claims 1 or 3, CHARACTERIZED IN THAT the set of signals comprises a plurality of traffic signals and at least one control signal.

7.  The method of claim 1, CHARACTERIZED IN THAT the scaling factor is further based on the power level of the set for the time period, and a scaling factor for a previous time period.

8.  The method of claim 1, CHARACTERIZED IN THAT the threshold power level comprises any value between about 75% and about 150% of the amplifier's maximum continuous power level.

9.  The method of claim 3, CHARACTERIZED IN THAT the scaling step comprises scaling the power level of each of the signals in the signal set individually using the corresponding scaling factor.

10. The method of claim 3, CHARACTERIZED IN THAT:

    the obtaining step comprises obtaining the power level ($P[n-1]$ of the set for a current time period;
    the determining step comprises determining a scaling factor ($g[n]$) based on the power level ($P[n-1]$) of the set for the current time period, a scaling factor ($g[n-1]$) determined using a power level obtained for a previous time period, and the threshold power level ($P_{th}$); and
    the scaling step comprises scaling the power level ($P[n-1]$) obtained for the current time period using the scaling factor ($g[n-1]$) determined using the power level obtained for the previous time period.

11. The method of claim 3, CHARACTERIZED IN THAT:

    the obtaining step comprises obtaining the power level ($P[n-1]$) of the set for a current time period;
    the determining step comprises determining a scaling factor ($g[n]$) based on the power level ($P[n-1]$) of the set for the current time period, a scaling factor ($g[n-1]$) determined using a power level obtained for a previous time period, and the threshold power level ($P_{th}$); and

the scaling step comprises scaling the power level ($P[n-1]$) obtained for the current time period using the scaling factor ($g[n-1]$) determined using the power level obtained for the current time period.

**12.** The method of claim 3, CHARACTERIZED IN THAT the base station comprises a plurality of amplifiers, each for amplifying a set of signals and wherein:

the obtaining step comprises obtaining power level for each set of signals for the time period;

the determining step comprises determining a scaling factor for each set of the signals; and

the scaling step comprises scaling the power level of each set of signals using the scaling factor determined for that set.

**13.** The method of claim 3, CHARACTERIZED IN THAT the time period comprises a frame.

**14.** The method of claim 3, CHARACTERIZED IN THAT the time period comprises a power control group.

FIG. 1

(PRIOR ART)

100

110

CONTROL CHANNELS

120

TRAFFIC CHANNELS

130

COMBINER

Σ

140

MODULATOR

160

150

AMPLIFIER

FIG. 2

200

110 — CONTROL CHANNELS

120 — TRAFFIC CHANNELS

COMBINER

Σ

210

310

320

Σ

140
MODULATOR

150
AMPLIFIER

160

POWER LEVEL

SCALING FACTOR

P[n-1]

g[n]

220 — OC

240 — MEMORY

SYSTEM PARAMETERS
$P_{th}, \lambda$

EP 1 071 226 A1

10

**FIG. 3**

220

MEM

240 — $\frac{1}{\lambda} * P_{th}$

MEM

$1.0 - \frac{1}{\lambda}$ —260

MEM

290 — $1.0$

$P[n-1]$

$Y$    $X$

$X \div Y$

230

$+$

250

$*$

270

$C$   280

$D$

$min \{C,D\}$

$g[n]$

$g[n-1]$

DELAY

300

FIG. 4

400

110

CONTROL CHANNELS

120

TRAFFIC CHANNELS

410

$\Sigma$

310

160

140

150

MODULATOR

AMPLIFIER

POWER LEVEL

SCALING FACTOR

$P[n-1]$

$g[n]$

240

MEMORY

SYSTEM PARAMETERS

$P_{th}, \lambda$

220

OC

EP 1 071 226 A1

FIG. 5

EP 1 071 226 A1

FIG. 6

**European Patent Office**

**EUROPEAN SEARCH REPORT**

Application Number

EP 00 30 5859

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | US 5 715 526 A (WEAVER JR LINDSAY A ET AL) 3 February 1998 (1998-02-03)<br>* column 5, line 43 - column 6, line 17 *<br>* column 7, line 57 - column 8, line 3 *<br>* column 9, line 29 - line 53 *<br>* column 11, line 52 - column 14, line 33 *<br>* column 21, line 57 - column 23, line 3 *<br>* figure 10 * | 1 | H04B7/005<br>H03G3/30 |
| A | EP 0 805 568 A (TRW INC)<br>5 November 1997 (1997-11-05)<br>* column 8, line 6 - line 39 *<br>* column 15, line 19 - line 58 *<br>* figures 2A,8 * | 1 | |
| A | US 5 708 681 A (MALKEMES ROBERT C ET AL)<br>13 January 1998 (1998-01-13)<br>* column 3, line 35 - column 4, line 23 *<br>* column 5, line 19 - column 7, line 18 *<br>* column 8, line 17 - line 67 *<br>* figure 2 * | 1 | |
| | | | TECHNICAL FIELDS SEARCHED (Int.Cl.7)<br>H04B<br>H03G |

The present search report has been drawn up for all claims

| Place of search | Date of completion of the search | Examiner |
|---|---|---|
| THE HAGUE | 24 November 2000 | Gkeli, M |

## ANNEX TO THE EUROPEAN SEARCH REPORT
## ON EUROPEAN PATENT APPLICATION NO.

EP 00 30 5859

This annex lists the patent family members relating to the patent documents cited in the above-mentioned European search report.
The members are as contained in the European Patent Office EDP file on
The European Patent Office is in no way liable for these particulars which are merely given for the purpose of information.

24-11-2000

| Patent document cited in search report | | Publication date | Patent family member(s) | | Publication date |
|---|---|---|---|---|---|
| US 5715526 | A | 03-02-1998 | AU | 704781 B | 06-05-1999 |
| | | | AU | 7155996 A | 27-03-1997 |
| | | | CA | 2237903 A | 13-03-1997 |
| | | | CN | 1208519 A | 17-02-1999 |
| | | | EP | 0855111 A | 29-07-1998 |
| | | | WO | 9709794 A | 13-03-1997 |
| EP 0805568 | A | 05-11-1997 | US | 5924015 A | 13-07-1999 |
| | | | CA | 2202845 A | 30-10-1997 |
| | | | DE | 69700102 D | 04-03-1999 |
| | | | DE | 69700102 T | 02-06-1999 |
| | | | JP | 2974981 B | 10-11-1999 |
| | | | JP | 10098425 A | 14-04-1998 |
| US 5708681 | A | 13-01-1998 | AU | 6376996 A | 12-11-1997 |
| | | | CA | 2247890 A | 30-10-1997 |
| | | | CN | 1217099 A | 19-05-1999 |
| | | | JP | 11508755 T | 27-07-1999 |
| | | | WO | 9740584 A | 30-10-1997 |

EPO FORM P0459

For more details about this annex : see Official Journal of the European Patent Office, No. 12/82